# EUROPEAN PATENT APPLICATION

(11) **EP 4 718 451 A1**
(43) Date of publication of application: **01.04.2026**
(21) Application number: 25203875.7
(22) Date of filing: 23.09.2025
(51) Int. Cl.: G11C 5/04, G06F 13/16, G06F 13/42, G11C 7/10

(54) **MEMORY DEVICE PROVIDING INTERCONNECTION BETWEEN COMPUTE UNITS IN MEMORY, AND OPERATING METHOD THEREOF**

(30) Priority: 27.09.2024 KR 20240131404
(71) Applicant: Korea Advanced Institute of Science and Technology, Daejeon 34141 (KR)
(72) Inventor: KIM, John Dongjun, 34141 Daejeon (KR); SON, Hyojun, 34141 Daejeon (KR)
(74) Representative: Manitz Finsterwald Patent- und Rechtsanwaltspartnerschaft mbB

(57) **Abstract**

A memory chip comprises memory banks, each memory bank including a compute unit. The memory banks are configured to be interconnected through an inter-bank network and perform inter-bank communication, and the compute unit is configured to perform a computation using data transmitted through the inter-bank network.

## Description

### BACKGROUND

### (a) Field

The present disclosure relates to processing-in-memory (PIM).

### (b) Description of the Related Art

Artificial intelligence (AI) technology has been used in various fields recently. However, the exponential increase in the computational demands of AI models has exposed the limitations of traditional central processing unit (CPU)-based computing systems in achieving desired performance. In particular, the AI models involving graph processing or embedding are being used in many social network and recommendation services. These applications are data-intensive with low data reuse. To handle such memory-intensive tasks, CPUs must constantly read data from memory to perform computation, leading to a bottleneck due to limited memory bandwidth and lowering overall resource utilization.

To solve the problems, processing-in-memory (PIM) is gaining attention. PIM maximizes the use of internal memory bandwidth by integrating a compute unit directly within the memory. This allows computation to be performed inside the memory itself, rather than by the CPU, which accelerates data processing by minimizing memory access delay.

While PIM is a promising next-generation memory technology that embeds compute units inside memory, it lacks direct communication support between the compute units in the memory. Therefore, to implement communication patterns that require compute unit interaction, such as reusing input data or accumulating output data, the CPU must retrieve all computation results from the memory, perform post-processing such as rearrangement/accumulation, and then send the post-processed results back to memory. This entire process forces all data movement through the memory bus between the memory and the CPU. This means that the communication bandwidth between the compute units in the memory is limited by the memory bus bandwidth. In general, the memory bus bandwidth is significantly lower than the internal bus bandwidth available to the compute units in the memory. Therefore, involving the CPU in communication between these internal compute units inevitably leads to lower overall performance.

### SUMMARY

The present disclosure attempts to provide a memory device for providing interconnection between compute units in a memory, and a method for operating the same.

An embodiment of the present disclosure provides a memory chip includes memory banks, each memory bank including a compute unit. The memory banks may be configured to be interconnected through an inter-bank network and perform inter-bank communication. The compute unit may be configured to perform computation using data transmitted through the inter-bank network.

The memory bank may include: the compute unit; a router connected to the inter-bank network and configured to perform data routing for the inter-bank communication; and a data memory that stores data used in computation of the compute unit. The router is configured to store received data in the data memory or forward the received data to the inter-bank network, depending on a data destination.

The memory bank may further include a data path for data movement in the inter-bank communication. As a processing-in-memory (PIM) network including the inter-bank network is activated, the data movement between the data memory and the PIM network may be performed through the data path.

The memory chip may further include a control interface configured to control compute units of the memory banks.

The inter-bank communication may be deterministically performed according to communication timing synchronized by control of the control interface.

The memory chip may further include a control circuit configured to, by control of the control interface, dynamically allocate data pins for communication with a host central processing unit or for communication with other memory chips.

The memory chip may be configured to be interconnected with other memory chips in the same rank through an inter-chip network and perform inter-chip communication.

The memory chip may be configured to be interconnected with memory chips in another rank through an inter-rank network and perform inter-rank communication.

Another embodiment of the present disclosure provides a memory device including memory chips that provides processing-in-memory (PIM). The memory chips may be configured to be interconnected through an inter-chip network and perform inter-chip communication. Memory banks in each memory chip may be configured to be interconnected through an inter-bank network and perform inter-bank communication. A compute unit in each memory bank may be configured to perform computation using data transmitted through the inter-chip network or the inter-bank network.

The memory bank may include: the compute unit; a router connected to the inter-bank network and configured to perform data routing for the inter-bank communication; and a data memory that stores data used in computation of the compute unit. The router may be configured to store received data in the data memory or forward the received data to the inter-bank network depending on the data destination.

The memory bank may further include a data path for data movement in the inter-bank communication or the inter-chip communication. As a processing-in-memory (PIM) network including the inter-bank network and the inter-chip network is activated, the data movement between the data memory and the PIM network may be performed through the data path.

The memory chip may further include a control interface configured to control compute units of internal memory banks.

The inter-bank communication may be deterministically performed according to communication timing synchronized by control of the control interface.

The memory device may further include a control circuit configured to, by control of the control interface, dynamically allocate data pins for communication with a host central processing unit or communication with other memory chips.

The memory chip may further include a memory interface connected to the inter-chip network. The control interface may be configured to exchange an inter-chip synchronization signal with the memory interface.

According to the present disclosure, the communication overhead using the host CPU may be eliminated and the internal bandwidth of the memory may be fully used through the network directly connecting the memory banks, each including the compute unit.

According to the present disclosure, while inter-bank communication may be processed in the memory chip through the inter-bank network, and inter-chip communication may be processed through the inter-chip network in parallel, thereby increasing communication efficiency between the compute units in the memory.

According to the present disclosure, computation is performed inside the memory through intra-memory communication without intervention from the host CPU, allowing significant improvements of the memory near-processing performance for memory-intensive and communication-intensive applications.

According to the present disclosure, the compute unit may expand its access range beyond just the local memory bank directly connected through the memory internal network to include remote memory banks, thereby improving overall computation efficiency and performance by performing global computations, such as post-processing or data rearrangement conventionally handled by the CPU, directly in the memory device.

According to the present disclosure, the collective communication rate may be increased by enhancing the computation performance of the PIM memory, and as a result, various applications requiring collective communication may be accelerated.

### BRIEF DESCRIPTION OF THE DRAWINGS

FIG. 1 shows a structure of a computing system.
FIG. 2 shows a hierarchical structure of a memory device.
FIG. 3 shows an interconnection network of a memory device according to an embodiment.
FIG. 4 shows an interconnection network topology of memory chips according to an embodiment.
FIG. 5 shows an interconnection network of memory ranks according to an embodiment.
FIG. 6 shows an interconnection network topology of memory banks according to an embodiment.
FIG. 7 shows a schematic view of a memory bank according to an embodiment compute unit.
FIG. 8 shows a schematic diagram of a memory chip for supporting inter-bank communication according to an embodiment.
FIG. 9 shows a schematic diagram of a memory chip for providing a dynamic bandwidth for inter-chip communication according to an embodiment.
FIG. 10 shows a bank connection of a memory chip according to an embodiment.
FIG. 11 shows a flowchart on internal communication of a memory according to an embodiment.
FIG. 12 shows an address generator for internal communication of a memory according to an embodiment.

### DETAILED DESCRIPTION OF THE EMBODIMENTS

In the following detailed description, only certain embodiments of the present disclosure have been shown and described, simply by way of illustration. As those skilled in the art would realize, the described embodiments may be modified in various different ways, all without departing from the spirit or scope of the present disclosure. Accordingly, the drawings and description are to be regarded as illustrative in nature and not restrictive, and like reference numerals designate like elements throughout the specification.

In the description, reference numerals and names are arbitrarily shown for understanding and ease of description, but the present disclosure is not limited thereto.

Unless explicitly described to the contrary, the word "comprise", and variations such as "comprises" or "comprising", will be understood to imply the inclusion of stated elements but not the exclusion of any other elements. In addition, the terms "-er", "-or", and "module" described in the specification mean units for processing at least one function and operation, and may be implemented by hardware components or software components, and combinations thereof.

In the present specification, an expression recited in the singular may be construed as singular or plural unless the expression "one", "single", etc., is used. Terms including ordinal numbers such as first, second, and the like, will be used only to describe various components, and are not to be interpreted as limiting these components. The terms are only used to differentiate one component from others.

In the flowcharts described with reference to the drawings in this specification, the operation order may be changed, various operations may be merged, certain operations may be divided, and certain operations may not be performed.

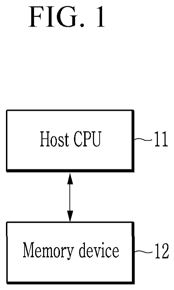

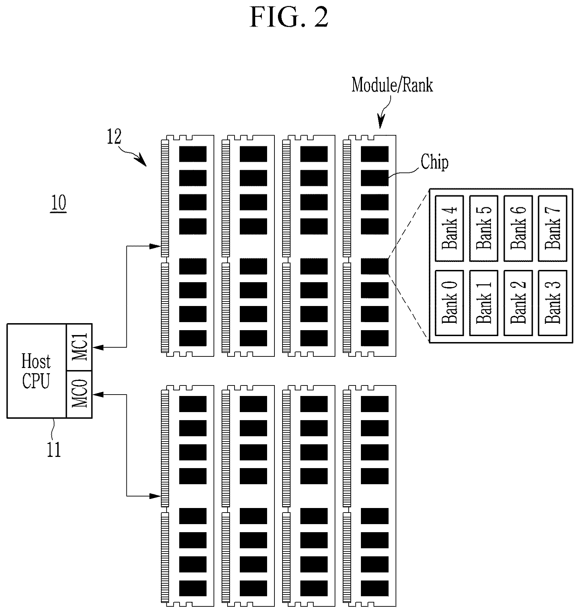

FIG. 1 shows a structure of a computing system, and FIG. 2 shows a hierarchical structure of a memory device.

Referring to FIG. 1, the computing system 10 includes a host central processing unit (CPU) 11, and a memory device 12. The host CPU 11 may be connected to the memory device 12 through a bus.

The host CPU 11 executes commands to perform various operations such as computation or control. The host CPU 11 may be replaced with other processing devices, for example, a graphics processing unit (GPU), and an application processor (AP).

The memory device 12 represents a memory that stores data accessed and used by the host CPU 11, and for example, it may include a dynamic random-access memory (DRAM).

The memory device 12 may have a hierarchical structure shown in FIG. 2. The memory device 12 may be configured with memory modules, and each memory module may have at least one rank. Each rank may include memory chips (e.g., DRAM chips), and each memory chip may include memory banks (e.g., Bank 0 to Bank 7). The memory module may, for example, be a dual in-line memory module (DIMM), and may be variable depending on package shapes.

As described, the memory device 12 maximizes memory parallelism and uses a hierarchical structure to increase the bandwidth. However, because the host CPU 11 performs the entire operation on the data, performance is limited by the bus bandwidth between the host CPU 11 and the memory device 12. To solve the problem, a processing-in-memory (PIM), which places compute units inside the memory, has emerged. Yet, conventional PIM memory lacks an interconnection structure (interconnect) for data communication in the memory device. This means memory banks including compute units have to communicate with other nodes through data pins designated for external connections to the memory chip. Therefore, when compute units need to communicate, they must do indirect communication through external data pins, which may degrade performance.

Therefore, this disclosure will describe a memory device for supporting the interconnect between the compute units in the memory to resolve inefficiency of communication in the memory, and an operation method thereof. The interconnect between the compute units in the memory may refers to the interconnect between memory nodes, each including at least one compute unit.

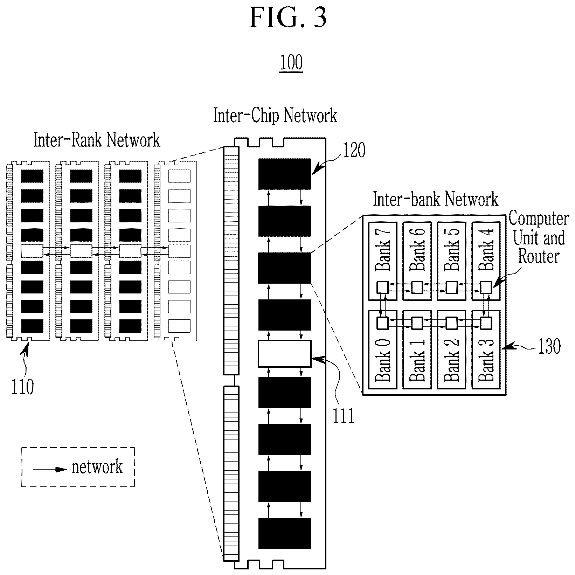

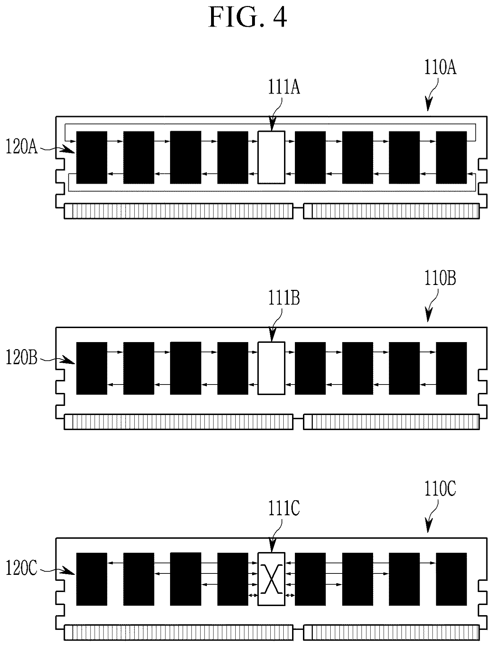

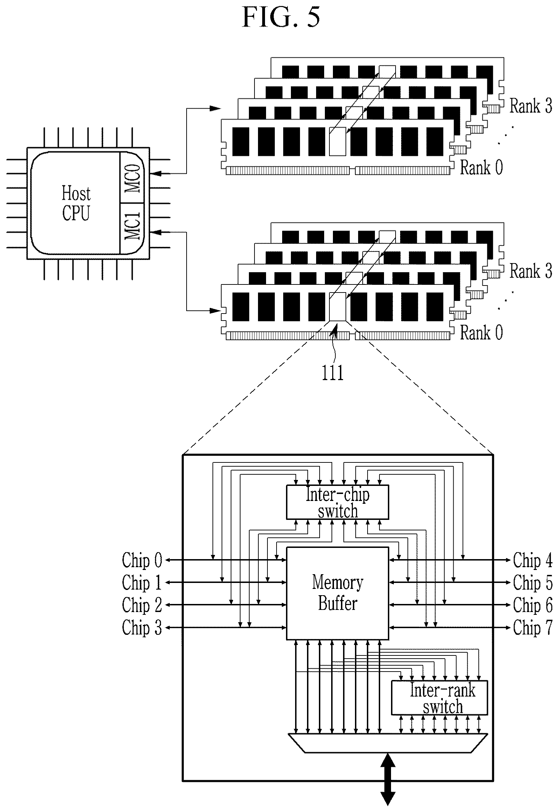

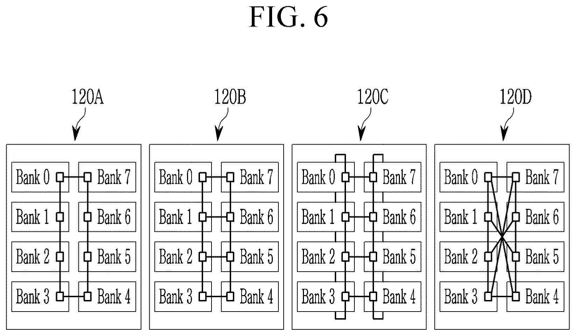

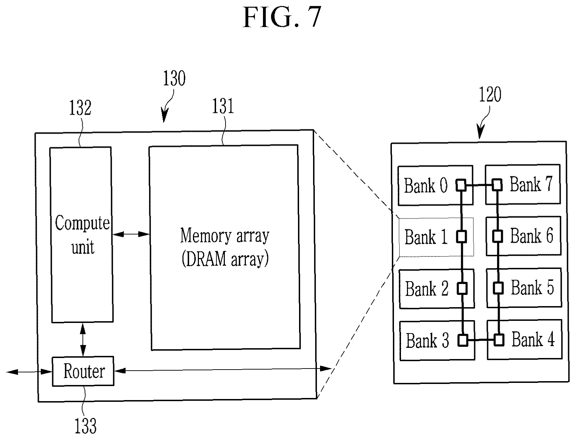

FIG. 3 shows an interconnection network of a memory device according to an embodiment, FIG. 4 shows an interconnection network topology of memory chips according to an embodiment, FIG. 5 shows an interconnection network of memory ranks according to an embodiment, FIG. 6 shows an interconnection network topology of memory banks according to an embodiment, and FIG. 7 shows a schematic view of a memory bank according to an embodiment compute unit.

Referring to FIG. 3, the memory device 100 is a PIM-enabled memory including compute units performing processing-in-memory (PIM).

The memory device 100 may be configured with memory modules/ranks 110. Each of the memory modules may include memory chips 120, and each memory chip may include memory banks (e.g., Bank 0 to Bank 7) 130. Note that "memory module" or "memory rank", which are a higher level than memory chips, may be used interchangeably here, and multiple ranks may exist in a single memory module depending on its packaging.

The compute unit may be embedded in each memory bank 130. The memory bank including compute units may be referred to as a PIM bank, the memory chip including PIM banks may be referred to as a PIM chip, and the memory device including PIM chips may be referred to as a PIM memory device. In the present disclosure, "compute unit" may represent the unit within the memory device 100, and may be referred to as a PIM compute unit or a DRAM processing unit (DPU) to distinguish it from the host CPU.

The memory device 100 may interconnect the banks in the memory chip through an inter-bank network, may interconnect the memory chips in the memory module through an inter-chip network, and may interconnect different ranks (or DIMMs) through an inter-rank network. The memory device 100 may support direct communication between its internal compute units using an on-chip network for interconnecting the compute units in the memory chip and an off-chip network for interconnecting the other memory chips. Data from a specific memory bank may be routed from its source to its destination through the inter-bank, inter-chip, and inter-rank network. The entire network, which directly connects the compute unit-equipped banks in the chip and interconnects the chips in a memory hierarchical structure, may be referred to as a PIMnet. A memory unit including compute units may be considered a network node, with the PIM bank being the lowest PIM node.

The chips in the memory module, and the memory modules may be interconnected through an interconnect node 111 implemented in the memory module. For example, the interconnect node 111 may establish an interconnect link using pins allocated in a ball grid array (BGA) packaging, such as a DQ pin allocated to a data bus connected to the CPU, a CMD/ADDR pin for forwarding command/address signals, and a no connection/ no function (NC/NF) pin not allocated in transmitting control signals/data. The interconnect node 111 may include a routing logic for inter-rank interconnect. The interconnect node 111 may be implemented using a buffer chip provided in a registered DIMM (RDIMM), which is often used as a memory module for a server, depending on the network topology. For example, a crossbar topology may use a buffer chip, while a mesh or ring topology may be implemented without using the buffer chip.

Referring to FIG. 4, various network topologies can be used to interconnect memory chips within a memory rank. For example, memory chips 120A in a memory module 110A may be interconnected using a ring topology passing through an interconnect node 111A. Memory chips 120B in a memory module 110B may be interconnected using a mesh topology passing through an interconnect node 111B. Memory chips 120C in a memory module 110C may be interconnected using a crossbar topology through an interconnect node 111C.

Referring to FIG. 5, memory chips in a single memory module may be interconnected with other memory modules through the inter-rank interconnection network. The interconnect node 111 in the memory module may, for example, configure an interconnect link using various pins, such as a DQ pin used in data transmission in a memory module standard such as a DIMM, a CMD/ADDR pin, and a pin to which no specific function is allocated. For inter-rank communication, an inter-rank multidrop DDR bus, already present in DRAM, may be used as a broadcast bus.

The interconnect node 111 may include a memory buffer, an inter-chip switch for connecting chips, and an inter-rank switch for inter-rank connections.

Referring to FIG. 6, regarding the single memory chip, the network topology for interconnecting banks including compute units may be various. For example, the memory chip 120A may interconnect its banks using a ring topology. The memory chip 120B may interconnect its banks using a mesh topology. The memory chip 120C may interconnect its banks using a torus topology. The memory chip 120D may interconnect it banks using a fully connected topology.

Referring to FIG. 7, each memory bank 130 in the memory chip 120 may include a memory array (or DRAM array) 131, a compute unit 132 and a router 133. The memory bank 130 also feature a data link for inter-bank or inter-chip data transmission. This design allows memory banks in a single chip to communicate directly through the inter-bank network, without involving a CPU. Similarly, memory banks from different chips may communicate directly through the inter-chip network, also without involving the CPU.

The router 133 may be configured as a simple logic. The router 133 may be configured to receive data from neighboring banks, and accept the data that is its destination or forward the data to the network. Also, the router 133 is configured to transmit local data to the destination through the network. When communication timing is deterministic and inter-bank communication uses the ring-based topology, a control signal for conditional data reception in the router 133 may not be needed, and the compute unit 132 may decide whether to use the data arrived at the router 133. This design choice can eliminate the need for a ready/valid signal interface within the interconnection network.

To use the router 133 implemented with a simple logic, the memory chip 120 may use a control interface to manage the execution states of the memory banks, enabling centralized flow control. The control interface may include a control register that stores the execution states for each memory bank in the memory chip. These states may include pre-processing, transmitting, and post-processing steps for collective communication. The control register may help manage the communication states for collective communication or other communication where information such as source, destination, traffic amount is established.

By directly connecting the memory banks including compute units, the memory device 100 may efficiently process collective communication. This is particularly beneficial for various applications, including large-scale distributed processing and machine learning.

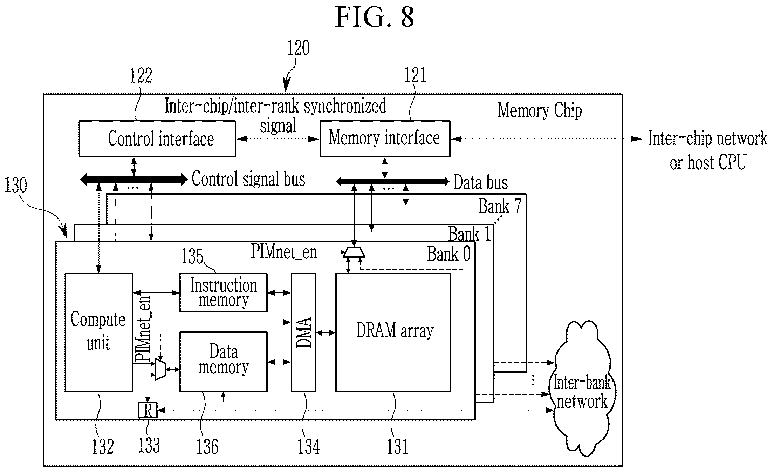

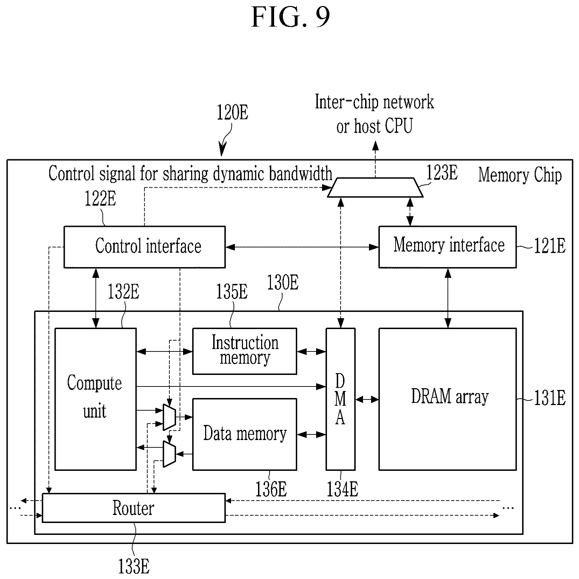

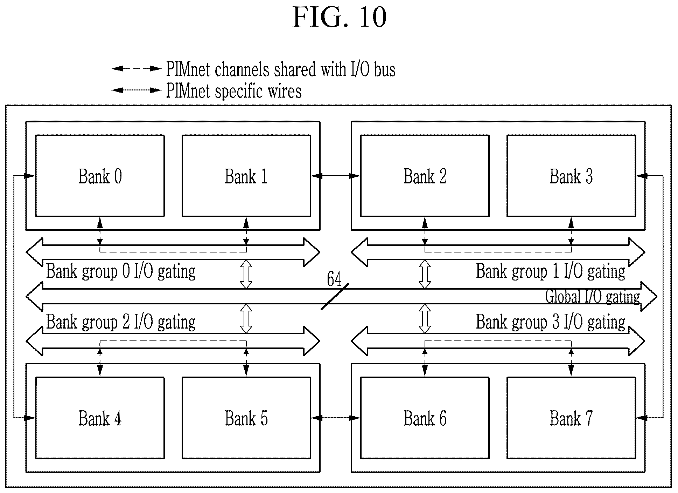

FIG. 8 shows a schematic diagram of a memory chip for supporting inter-bank communication according to an embodiment, FIG. 9 shows a schematic diagram of a memory chip for providing a dynamic bandwidth for inter-chip communication according to an embodiment, and FIG. 10 shows a bank connection of a memory chip according to an embodiment.

Referring to FIG. 8, the memory chip 120 may include memory banks (Bank 0 to Bank 7) 130. The banks may support direct communication among themselves through the inter-bank network. The memory chip 120 may communicate with the host CPU, and also with other memory chips through the inter-chip/inter-rank network, without involving the host CPU.

The memory chip 120 may include a memory interface 121, which enables external access to the internal memory. The memory interface 121 may facilitate reading from or writing to the data stored in the memory array 131 through a data bus. That is, the host CPU may read data from the memory array or may write data on the memory array through the memory interface 121.

The memory chip 120 may include a control interface 122 to manage the execution states of the memory banks by controlling the compute unit 132 in the memory bank 130. It may orchestrate centralized flow control like inter-bank synchronization. The compute unit 132 may be configured to perform inter-bank communication at inter-bank synchronized timing by control of the control interface 122. The control interface 122 and the memory interface 121 may transmit and receive inter-chip/inter-rank synchronization signals, which allows for inter-chip/inter-rank communication to occur with synchronized timing.

The memory bank 130 may include a memory array (or a DRAM array) 131, a compute unit 132 for processing-in-memory (PIM), a router 133 for inter-bank communication, and a PIM data path (represented by a dotted line in FIG. 8) for data movement during inter-bank communication and inter-chip communication. When the network for the processing-in-memory (PIM) is activated, data may flow through the PIM data path, and the PIM network may be activated by asserting PIMnet_en signal. Activation of the PIM network may be controlled by the control interface 122 or a device responsible for controlling communication timing.

The memory bank 130 includes modules for computation by the compute unit 132 and data storage. For example, these modules may include a direct memory access (DMA) module 134, an instruction memory 135, a data memory 136, etc. Data stored in the data memory 136 may be used by the directly connected compute unit 132, or by the compute unit connected through inter-bank/inter-chip communication. That is, the data of the data memory 136 may be transmitted to the destination needing the data by inter-bank/inter-chip communication, and the data obtained by the inter-bank/inter-chip communication may be stored in the data memory 136. The DMA module 134 may be responsible for data movements between the memory array 131 and the data memory 136.

When the processing-in-memory (PIM) network is activated (by PIMnet_en), a path for data transmission between banks in the memory chip 120 through the inter-bank network may be used. Data intended for a specific destination may be received through the router 133 or the data may be transmitted to its destination through the router 133. That is, the data from the data memory 136 may be transmitted to another memory bank (the destination) through the router 133, and the data transmitted from another memory bank (the source) may be stored in the data memory 136 through the router 133. The inter-bank communication is scheduled to prevent contention, eliminating the need for an input buffer or hardware-based arbitration for the router 133. The router 133 may use simple logic: it determines whether to eject a received packet if its bank is the destination, or to forward the it to the connected bank otherwise. The simple logic ensures that the standby time between the source and the destination is deterministic, as there is no non-determination such as queuing or arbitration. This design results in a deterministic interconnection network.

When the processing-in-memory (PIM) network (by PIMnet_en), a data path is established from the memory interface 121 to the data memory 136. This path facilitates inter-chip communication, which also includes inter-rank communication.

To ensure deterministic communication in the interconnection network, the communication scheduling is crucial. This scheduling synchronizes communication timing and identifies potential contentions for communication resources. While synchronization may be achieved by a ready signal, and the scheduling may be differently performed depending on collective communication method. For example, AllReduce communication may be performed in multiple steps based on a ring algorithm. All-to-All communication may use the ring algorithm for the inter-bank communication, but employ a permuted injection pattern for inter-chip/inter-rank communication to prevent contention on an inter-chip switch, a switch, or a multi-drop memory bus.

The inter-chip communication may be implemented using at least some pins (e.g., DQ pins) of the memory chip. For example, when the inter-chip network uses a crossbar topology, eight DQ pins in a DDR4 DRAM may be partitioned into four pins for transmitting data to the interconnect node (or buffer chip) and four pins for receiving data. Although the DQ pins are generally bidirectional, they may be configured as two unidirectional channels for inter-chip communication. Since inter-chip communication does not match host-memory communication, the DQ pins may be shared. The DQ pins may be routed to the buffer chip before being driven by the DIMM through the memory channel bus. Once routed to the buffer chip, they may connect to an 8×8 inter-chip crossbar switch, providing inter-chip communication. The buffer chip may further include a switch control device (not shown) to manage the synchronization of inter-chip communication in addition to the crossbar. When the ready signals are collected from each chip, and all the chips are confirmed "ready", a launch signal may be transmitted to all the chips, initiating inter-chip communication.

The crossbar in the interconnect node (or buffer chip) has no hardware arbitration function but may be managed or scheduled to prevent contention. When inter-chip communication is needed, during initial synchronization, individual chips may transmit control information to the switch control device before data transmission begins and then may transmit data to the buffer chip. The control information may include a traffic pattern (e.g., source and destination) and a message size.

The control interface of the inter-chip switch may use the existing data bus. The inter-chip switch may include a control register that is memory-mapped to store switch control information.

Referring to FIG. 9, the memory chip 120E may be configured to provide dynamic bandwidth for inter-chip communication. Similar to the memory chip shown in FIG. 8, the memory chip 120E may include a memory interface 121E, a control interface 122E, and memory banks. Each memory bank 130E may include a memory array 131E, a compute unit 132E, a router 133E, a DMA module 134E, an instruction memory 135E, a data memory 136E, and a PIM data path. The memory chip 120E may further include a control circuit 123E, which facilitates dynamic bandwidth sharing. This circuit may allocate the bandwidth connected to the outside of the chip to the existing memory bandwidth or the inter-chip network according to a control signal.

The control circuit 123E may dynamically allocate the data pins (or DQ pin) of the memory chip 120E for communication with the CPU or for communication with other memory chips according to the control signal of the control interface 122E. By dynamically allocating pins based on the bandwidth demands for inter-chip communication or communication with the CPU, the memory chip 120E may maximize the communication performance.

The data transmitted through the PIM network may be stored in the data memory 136E through the router 133E, and the data stored in the data memory 136E may be transmitted to its intended destination through the PIM network. Referring to FIG. 10, the inter-bank network may be interconnected as a ring topology. To minimize the impact on wire routing resources, the existing I/O bus in the memory chip may be used.

Regarding the internal hierarchical DRAM I/O bus structure, the DDR I/O bus, typically used for general memory access, may be shared for inter-bank communication. This is feasible because inter-bank communication does not involve repetitive memory access or host-memory communication. For example, considering a 64-bit baseline I/O bus, its hierarchical design might allow two banks or bank groups to share one set of I/O buses, while the next bank group shares a global I/O bus. Typically, a bank group I/O bus configured as a 64bit bi-directional bus may be divided into four 16-bit unidirectional channels for a ring connection. These channels may then provide four input/output channels from east/west ports.

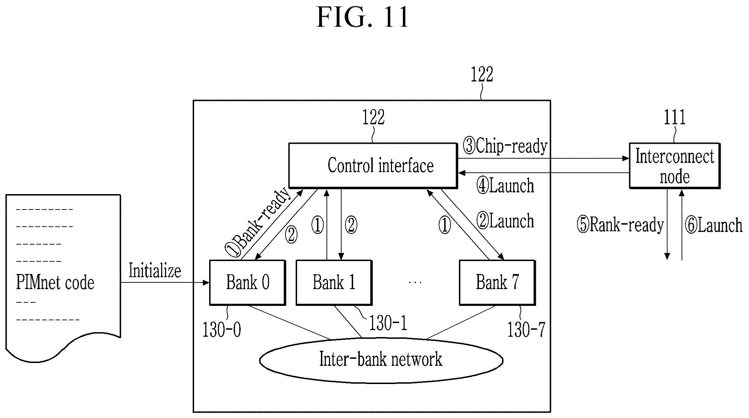

FIG. 11 shows a flowchart on internal communication of a memory according to an embodiment.

Referring to FIG. 11, each of the memory banks 130-0, 130-1, ..., 130-7 in the memory chip 122 transmits a bank-ready signal to the control interface 122 placed in the memory chip (①). The bank-ready signal indicates that the respective memory bank is ready for communication, thereby synchronizing a starting point of communication.

Upon receiving the ready signals from all memory banks, the control interface 122 transmits a launch signal to the all memory banks in the memory chip when the communication range is limited to the inside of the memory chip 122, the launch signal indicating the start of communication (②). Communication may proceed in the memory chip through the inter-bank network.

When the communication range includes memory chips, the control interface 122 transmits a chip-ready signal to the interconnect node 111, the chip-ready signal indicating that memory chip 122 is ready to begin communication (③).

Upon receiving the ready signals from all memory chips in the memory rank 110, the interconnect node 111 transmits a launch signal to the control interfaces in the corresponding memory rank when the communication range is limited to the inside of the memory rank (④). The communication may occur in the memory rank through the inter-chip network.

When the communication range includes memory ranks, the interconnect node 111 transmits a rank-ready signal to the interconnect node of another memory rank, the rank-ready signal indicating that memory rank is ready to begin communication (⑤). In a like way, when the ready signal is transmitted from the memory ranks, the interconnect node 111 may receive the launch signal (⑥). By this, inter-rank communication may be performed. In scenarios where there are multiple interconnect nodes in the memory ranks, the designated node among the interconnect nodes may receive ready signals from the all memory ranks and may generate a launch signal.

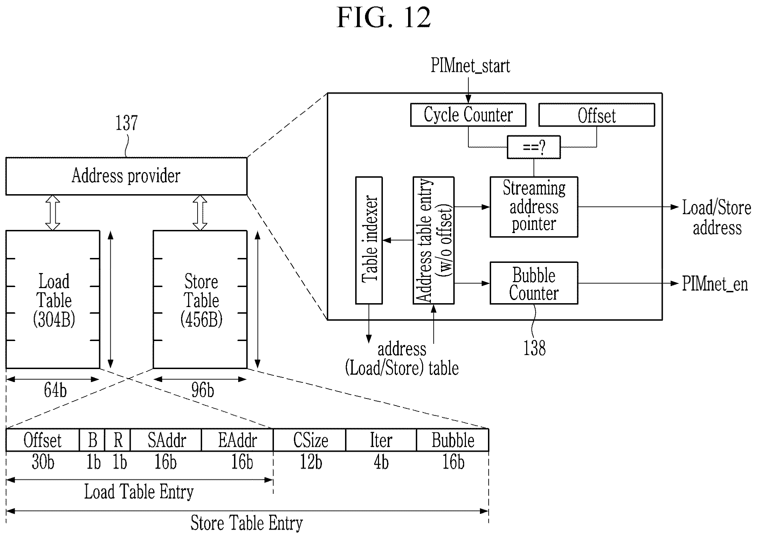

FIG. 12 shows an address generator for internal communication of a memory according to an embodiment.

Referring to FIG. 12, in conventional PIM system, the host CPU is involved in computation of the compute units in the memory, and is aware of the node address for data communication. However, the PIM-enabled memory device 100 according to the present disclosure needs address information to perform collective communication in the memory without involving the host CPU. For this, the memory bank 130 may include an address provider 137.

For example, the address provider 137 may generate the memory access addresses for communication of each memory bank until a specific communication stage is completed. This process starts from a base address stored in a load/store table, which contains entries for different stages of communication. The communication stage may be defined as a process where a source memory bank transmits data for a continuous address space within a single communication layer (e.g., inter-bank communication, inter-chip communication, and inter-rank communication) according to a given network topology. The number of communication stages may be determined based on the number of different continuous address spaces required by source memory banks for the communication pattern (e.g., AllReduce, and All-to-all). For reference, the size of the load/store table and the size of the table entry in FIG. 12 are provided as examples and may vary depending on the network topology, communication pattern, and memory structure.

Collective communication in the memory device 100 is processed in multiple stages, and the number of stages may vary depending on the collective traffic type, the number of PIM banks, and the interconnect topology. Since this information is known prior to execution, the node addresses used during communication may be generated by the host CPU during compilation phase.

To ensure contention-free communication in the PIM network, timing information is essential. As with addresses, all parameters necessary for timing calculation (e.g., channel standby time, standby time after synchronization) may be known prior to execution. This allows the host CPU to generate timing information for each PIM bank along with address information.

The addresses of the memory banks generated by the host CPU may be stored in the bank, for example, in the memory array 131 or the data memory 136 as shown in FIG. 8. The address provider 137 may be responsible for checking the bank address for internal memory communication by looking up the required bank address for each stage of internal memory communication from the memory array 131 or the data memory 136.

A bubble counter 138 may be added to each bank for traffic scheduling based on timing information. The bubble counter 138 may control the start time of inter-bank communication, and may store timing information including the communication start times of the respective stages of collective communication, as generated by the host CPU, and may delay the start of communication of the respective stages according to the timing information. It is described that the address provider 137 includes the bubble counter 138, and the logic may be implemented in various ways.

According to the present disclosure, the communication overhead using the host CPU may be eliminated and the internal bandwidth of the memory may be fully used through the network directly connecting the memory banks, each including the compute unit.

According to the present disclosure, while inter-bank communication may be processed in the memory chip through the inter-bank network, and inter-chip communication may be processed through the inter-chip network in parallel, thereby increasing communication efficiency between the compute units in the memory.

According to the present disclosure, computation is performed inside the memory through intra-memory communication without intervention from the host CPU, allowing significant improvements of the memory near-processing performance for memory-intensive and communication-intensive applications.

According to the present disclosure, the compute unit may expand its access range beyond just the local memory bank directly connected through the memory internal network to include remote memory banks, thereby improving overall computation efficiency and performance by performing global computations, such as post-processing or data rearrangement conventionally handled by the CPU, directly in the memory device.

According to the present disclosure, the collective communication rate may be increased by enhancing the computation performance of the PIM memory, and as a result, various applications requiring collective communication may be accelerated.

While this disclosure has been described in connection with what is presently considered to be practical embodiments, it is to be understood that the invention is not limited to the disclosed embodiments, but, on the contrary, is intended to cover various modifications and equivalent arrangements included within the spirit and scope of the appended claims.

## Claims

1. A memory chip comprising
memory banks, each memory bank including a compute unit,
wherein the memory banks are configured to be interconnected through an inter-bank network and perform inter-bank communication, and
the compute unit is configured to perform computation using data transmitted through the inter-bank network.

2. The memory chip of claim 1, wherein the memory bank comprises:
the compute unit;
a router connected to the inter-bank network and configured to perform data routing for the inter-bank communication; and
a data memory that stores data used in computation of the compute unit, and
wherein the router is configured to store received data in the data memory or forward the received data to the inter-bank network, depending on a data destination.

3. The memory chip of claim 2, wherein the memory bank further comprises a data path for data movement in the inter-bank communication, and
wherein, as a processing-in-memory (PIM) network including the inter-bank network is activated, the data movement between the data memory and the PIM network is performed through the data path.

4. The memory chip of claim 1, further comprising
a control interface configured to control compute units of the memory banks.

5. The memory chip of claim 4, wherein the inter-bank communication is deterministically performed according to communication timing synchronized by control of the control interface.

6. The memory chip of claim 4, further comprising
a control circuit configured to, by control of the control interface, dynamically allocate data pins for communication with a host central processing unit or for communication with other memory chips.

7. The memory chip of claim 1, wherein the memory chip is configured to be interconnected with other memory chips in the same rank through an inter-chip network and perform inter-chip communication.

8. The memory chip of claim 7, wherein the memory chip is configured to be interconnected with memory chips in another rank through an inter-rank network and perform inter-rank communication.

9. A memory device comprising
memory chips that provides processing-in-memory (PIM),
wherein the memory chips are configured to be interconnected through an inter-chip network and perform inter-chip communication,
memory banks in each memory chip are configured to be interconnected through an inter-bank network and perform inter-bank communication, and
a compute unit in each memory bank is configured to perform computation using data transmitted through the inter-chip network or the inter-bank network.

10. The memory device of claim 9, wherein the memory bank comprises:
the compute unit;
a router connected to the inter-bank network and configured to perform data routing for the inter-bank communication; and
a data memory that stores data used in computation of the compute unit, and
wherein the router is configured to store received data in the data memory or forward the received data to the inter-bank network, depending on the data destination.

11. The memory device of claim 10, wherein the memory bank further comprises
a data path for data movement in the inter-bank communication or the inter-chip communication, and
wherein, as a processing-in-memory (PIM) network including the inter-bank network and the inter-chip network is activated, the data movement between the data memory and the PIM network is performed through the data path.

12. The memory device of claim 9, wherein the memory chip further comprises
a control interface configured to control compute units of internal memory banks.

13. The memory device of claim 12, wherein the inter-bank communication is deterministically performed according to communication timing synchronized by control of the control interface.

14. The memory device of claim 12, further comprising
a control circuit configured to, by control of the control interface, dynamically allocate data pins for communication with a host central processing unit or communication with other memory chips.

15. The memory device of claim 12, wherein the memory chip further comprises
a memory interface connected to the inter-chip network, and
the control interface is configured to exchange an inter-chip synchronization signal with the memory interface.
